# EUROPEAN PATENT APPLICATION

(11) **EP 3 462 604 A1**
(43) Date of publication of application: **03.04.2019**
(21) Application number: 18181517.6
(22) Date of filing: 03.07.2018
(51) Int. Cl.: H02S 20/20, F24S 25/636, F24S 25/30, F24S 25/12, H02S 30/00, F24S 25/60

(54) **BACK-HANG MOUNTING ASSEMBLY OF THIN FILM PHOTOVOLTAIC MODULE**

(30) Priority: 28.09.2017 CN 201721265700 U
(71) Applicant: Beijing Apollo Ding Rong Solar Technology Co., Ltd., Beijing 100176 (CN)
(72) Inventor: Jiang, Wei, Beijing, 100176 (CN); Lv, Hejiang, Beijing, 100176 (CN); Wang, Hong, Beijing, 100176 (CN)
(74) Representative: Schüssler, Andrea

(57) **Abstract**

The disclosure provides a back-hang mounting assembly of a thin film photovoltaic module, which includes: a back-hang hook plate of which a cross section is L-shaped and which includes a horizontal plate and a vertical plate, wherein the horizontal plate is fixedly connected to the photovoltaic module; a fixed beam which includes a base plate and a pair of opposite side plates fixed on the base plate, wherein the base plate is configured to be fixedly connected to a roof; and a fastener which passes through the vertical plate and the pair of side plates and fixedly connects the back-hang hook plate to the fixed beam. The back-hang mounting assembly provided by the disclosure includes the back-hang hook plate of which the cross section is L-shaped, where one side is fixedly connected to the photovoltaic module, and the other side is fixedly connected to the fixed beam by the fastener and then connected to the roof by the fixed beam, to thereby implement the installation of the photovoltaic module on the roof. Compared with the prior art, the damage to the glass is avoided, and furthermore the structure is simple and the installation is relatively convenient.

## Description

### Field

The disclosure relates to the mounting technique of the photovoltaic module, and particularly to a back-hang mounting assembly of a thin film photovoltaic module.

### Background

The solar energy is a kind of clean energy, of which the exploitation and utilization are valued by various countries in the world. How to efficiently collect and utilize the solar energy is fairly far-reaching for the environmental protection. The thin film is the future of the photovoltaic power generation, particularly along with the further improvement of the module efficiency, and the flexibility and thin film tendency will become the emerging development direction of the photovoltaic market gradually. But the thin film modules are mostly the frameless double-glazed modules, where the thin film modules have the higher installation breakage rate due to their special double-glazed structure and the improper operations in the installation.

The fixation of the thin film photovoltaic module in the related art needs to use the clamp to impact and fix in the front plate direction of the module, which often causes the breakage phenomenon of the pressed module glass due to the overexertion. Meanwhile there are the problems of blocking the light rays and affecting the electric energy production, and the installation operations are inconvenience and the construction progress is slow.

### Summary

The object of the disclosure is to provide a back-hang mounting assembly of a thin film photovoltaic module, to address the problem in the prior art, avoid the damage to the glass, and be convenient to install.

The disclosure provides a back-hang mounting assembly of a thin film photovoltaic module, which includes: a back-hang hook plate of which a cross section is L-shaped and which includes a horizontal plate and a vertical plate, wherein the horizontal plate is fixedly connected to the photovoltaic module; a fixed beam which includes a base plate and a pair of opposite side plates fixed on the base plate, wherein the base plate is configured to be fixedly connected to a roof; a fastener which passes through the vertical plate and the pair of side plates and fixedly connects the back-hang hook plate to the fixed beam.

In some embodiments, in the back-hang mounting assembly, the horizontal plate is fixedly connected to a glass back plate of the photovoltaic module.

In some embodiments, in the back-hang mounting assembly, the horizontal plate is fixedly connected to the glass back plate via a structural adhesive.

In some embodiments, the back-hang mounting assembly further includes an oblique beam on which the base plate is fixed and which is configured to be fixedly connected to the roof.

In some embodiments, the back-hang mounting assembly further includes a pillar of which a top end is fixedly connected to a side of the oblique beam far from the base plate and a bottom end is fixedly connected to the roof.

In some embodiments, in the back-hang mounting assembly, the material of the back-hang hook plate is aluminium alloy.

In some embodiments, in the back-hang mounting assembly, the number of back-hang hook plates is two, and two back-hang hook plates are perpendicular or parallel to each other.

In some embodiments, in back-hang mounting assembly, the back-hang hook plate is configured with an installation hole, the fastener is a bolt, and the bolt matches with the installation hole and is locked by a fastening nut.

In some embodiments, in the back-hang mounting assembly, the installation hole is a screw hole in size of M8.

In some embodiments, in the back-hang mounting assembly, each back-hang hook plate is configured with two installation holes.

In some embodiments, in the back-hang mounting assembly, the fixed beam is C-shaped steel of which a cross section is C-shaped.

The back-hang mounting assembly of the thin film photovoltaic module provided by the disclosure includes the back-hang hook plate of which the cross section is L-shaped, where one side is fixedly connected to the photovoltaic module, and the other side is fixedly connected to the fixed beam by the fastener and then connected to the roof by the fixed beam, to thereby implement the installation of the photovoltaic module on the roof. Compared with the prior art, the damage to the glass is avoided, and furthermore the structure is simple and the installation is relatively convenient.

### Brief Description of the Drawings

FIG.1 is a schematic structural diagram of a back-hang mounting assembly of a thin film photovoltaic module in accordance with an embodiment of the disclosure;
FIG.2 is a front view of a back-hang mounting assembly of a thin film photovoltaic module in accordance with an embodiment of the disclosure;
FIG.3 is an enlarged view of the part A in FIG.2; and
FIG.4 is a schematic overall diagram of a back-hang mounting assembly of a thin film photovoltaic module in accordance with an embodiment of the disclosure.

### Detailed Description

In order to make the objects, technical solutions and advantages of the disclosure clearer, the technical solutions of the embodiments of the disclosure will be described clearly and completely below in combination with the accompanying drawings of the embodiments of the disclosure. Obviously the described embodiments are a part of the embodiments of the disclosure but not all the embodiments. Based upon the embodiments of the disclosure, all of other embodiments obtained by those ordinary skilled in the art without creative work pertain to the protection scope of the disclosure.

The embodiments of the disclosure will be described below in details and the examples of these embodiments are shown in the drawings, in which the same or similar reference numbers represent the same or similar elements or the elements having the same or similar functions all the way. The embodiments described by reference to the drawings are exemplary and only used to explain the disclosure, but not interpreted as the limitations of the disclosure.

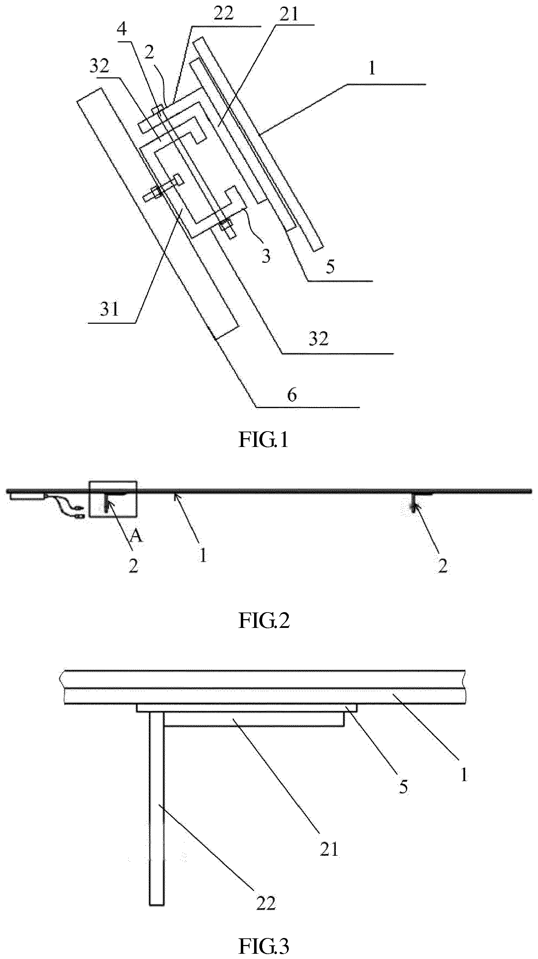

As shown in FIGs.1 to 3, an embodiment of the disclosure provides a back-hang mounting assembly of a thin film photovoltaic module, which includes a back-hang hook plate 2, a fixed beam 3 and a fastener 4. The cross section of the back-hang hook plate 2 is L-shaped, and the back-hang hook plate 2 includes a horizontal plate 21 and a vertical plate 22, where the horizontal plate 21 is fixedly connected to the photovoltaic module. The fixed beam 3 includes a base plate 31 and a pair of opposite side plates 32 fixed on the base plate 31, where the base plate 31 is configured to be fixedly connected to a roof. The fastener 4 passes through the vertical plate 22 and the pair of side plates 32 and fixedly connects the back-hang hook plate to the fixed beam 3.

The back-hang mounting assembly of the thin film photovoltaic module according to the embodiment of the disclosure includes the back-hang hook plate 2 of which the cross section is L-shaped, where one side is fixedly connected to the photovoltaic module, and the other side is fixedly connected to the fixed beam 3 by the fastener 4 and then connected to the roof by the fixed beam 3, to thereby implement the installation of the photovoltaic module on the roof. Compared with the related art, the damage to the glass is avoided, and furthermore the structure is simple and the installation is relatively convenient.

In some embodiments, as shown in FIGs.1 to 3, the photovoltaic module includes a glass back plate 1, a thin film solar battery chip and a glass top plate superposed successively.

FIG.1 only shows the glass back plate 1 exemplarily, and actually, the thin film solar battery chip and the glass top plate are superposed successively on the glass back plate 1 to form the double-glazed module. It can be understood by those skilled in the art that the mounting assembly according to the embodiment is not limited to being used on the double-glazed module, and the purpose thereof is to avoid the direct clamping of the back plate, so the applicable range of the mounting assembly is larger and not limited to the double-glazed module mentioned in the embodiment.

As shown in FIG.1, the horizontal plate 21 of the back-hang hook plate 2 is fixedly connected to the glass back plate 1 of the photovoltaic module.

The back-hang mounting assembly of the thin film photovoltaic module according to the embodiment includes the back-hang hook plate 2 of which the cross section is L-shaped, where one side is fixedly connected to the glass back plate 1, and the other side is fixedly connected to the fixed beam 3 by the fastener 4 and then connected to the roof by the fixed beam 3, to thereby implement the installation of the photovoltaic module on the roof. Compared with the related art, the damage to the glass is avoided, and furthermore the structure is simple and the installation is relatively convenient.

In some embodiments, the back-hang hook plate 2 is fixedly connected to the glass back plate 1 via the structural adhesive 5. It can be understood that the back-hang hook plate 2 may also be fixedly connected to the glass back plate 1 by the rivet joint, screw joint or others.

In some embodiments, the mounting assembly further includes an oblique beam 6 on which the base plate 31 of the fixed beam 3 is fixed. The oblique beam 6 is configured to be fixedly connected to the roof. The fixed beam 3 can be C-shaped steel of which the cross section is C-shaped, and the base plate 31 and the pair of side plates 32 form the C-shaped structure. The end of the side plate 32 far from the base plate 31 can further be configured with a folded plate, which makes the cross section of the fixed beam 3 form the shape of the inward closure, to thereby increase the installation stability of the fixed beam 3.

In some embodiments, the back-hang hook plate 2 may be configured with installation holes, which may be screw holes in size of M8. Each back-hang hook plate 2 is configured with two installation holes described above. The fastener 4 may be a bolt, which matches with the installation hole and is locked by a fastening nut.

The number of the back-hang hook plates 2 may be set according to the size of the photovoltaic module. In some embodiments, there are two back-hang hook plates 2 and the two back-hang hook plates 2 are perpendicular or parallel to each other to increase the installation strength of the photovoltaic module. The material of the back-hang hook plate 2 may be aluminium alloy, to thereby implement the lightweighting of the mounting structure.

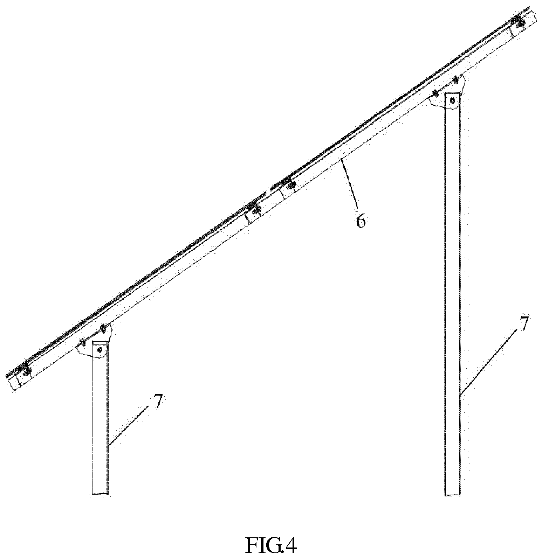

As shown in FIG.4, based on the above embodiments, the back-hang mounting assembly of the thin film photovoltaic module according to embodiments of the disclosure further includes a pillar 7. The top end of the pillar 7 is fixedly connected to the side of the oblique beam 6 far from the base plate 31 and the bottom end of the pillar 7 is fixedly connected to the roof. The pillar 7 may be fixedly connected to the oblique beam 6 by a bracket. The photovoltaic module is supported at a certain height by arranging the pillar 7, and the photovoltaic module is inclined at a certain angle by arranging the oblique beam 6, to thereby absorb the light better and increase the transformation efficiency of the electric energy.

The back-hang mounting assembly of the thin film photovoltaic module according to the disclosure includes the back-hang hook plate of which the cross section is L-shaped, where one side is fixedly connected to the photovoltaic module, and the other side is fixedly connected to the fixed beam by the fastener and then connected to the roof by the fixed beam, to thereby implement the installation of the photovoltaic module on the roof. Compared with the related art, the damage to the glass is avoided, and furthermore the structure is simple and the installation is relatively convenient.

The above embodiments shown by the drawings illustrate the constructions, features and effects of the disclosure in details, and the above embodiments are only the preferred embodiments of the disclosure, but the disclosure does not limit the implementation scope by the graphical representations. All the variations or modifications into the equivalent embodiments with the equivalent changes made based on the conception of the disclosure should come into the protection scope of the disclosure without departing from the spirit encompassed by the specification and drawings.

## Claims

1. A back-hang mounting assembly of a thin film photovoltaic module, **characterized in that**, comprising:
a back-hang hook plate of which a cross section is L-shaped and which comprises a horizontal plate and a vertical plate, wherein the horizontal plate is fixedly connected to the photovoltaic module;
a fixed beam which comprises a base plate and a pair of opposite side plates fixed on the base plate, wherein the base plate is configured to be fixedly connected to a roof; and
a fastener which passes through the vertical plate and the pair of side plates and fixedly connects the back-hang hook plate to the fixed beam.

2. The back-hang mounting assembly according to claim 1, wherein the horizontal plate is fixedly connected to a glass back plate of the photovoltaic module.

3. The back-hang mounting assembly according to claim 2, wherein the horizontal plate is fixedly connected to the glass back plate via a structural adhesive.

4. The back-hang mounting assembly according to claim 1, further comprising an oblique beam on which the base plate is fixed and which is configured to be fixedly connected to the roof.

5. The back-hang mounting assembly according to claim 4, further comprising a pillar of which a top end is fixedly connected to a side of the oblique beam far from the base plate and a bottom end is fixedly connected to the roof.

6. The back-hang mounting assembly according to any one of claims 1-5, wherein the material of the back-hang hook plate is aluminium alloy.

7. The back-hang mounting assembly according to claim 6, wherein the number of back-hang hook plates is two, and two back-hang hook plates are perpendicular or parallel to each other.

8. The back-hang mounting assembly according to any one of claims 1-5, wherein the back-hang hook plate is configured with an installation hole, the fastener is a bolt, and the bolt matches with the installation hole and is locked by a fastening nut.

9. The back-hang mounting assembly according to claim 8, wherein the installation hole is a screw hole in size of M8.

10. The back-hang mounting assembly according to claim 9, wherein each back-hang hook plate is configured with two installation holes.

11. The back-hang mounting assembly according to any one of claims 1-5, wherein the fixed beam is C-shaped steel of which a cross section is C-shaped.
